Europäisches Patentamt

European Patent Office

Office européen des brevets

(11) Veröffentlichungsnummer: **0 322 434 B1**

(12) **EUROPÄISCHE PATENTSCHRIFT**

(45) Veröffentlichungstag der Patentschrift: **20.10.93**

(51) Int. Cl.5: **H01L 23/36**

(21) Anmeldenummer: **88905778.2**

(22) Anmeldetag: **27.06.88**

(86) Internationale Anmeldenummer:
**PCT/EP88/00564**

(87) Internationale Veröffentlichungsnummer:
**WO 89/00339 (12.01.89 89/02)**

(54) **FLACHER KÖRPER, INSBESONDERE ZUR VERWENDUNG ALS WÄRMESENKE FÜR ELEKTRONISCHE LEISTUNGSBAUELEMENTE.**

(30) Priorität: **03.07.87 DE 3721958**

(43) Veröffentlichungstag der Anmeldung:
**05.07.89 Patentblatt 89/27**

(45) Bekanntmachung des Hinweises auf die Patenterteilung:
**20.10.93 Patentblatt 93/42**

(84) Benannte Vertragsstaaten:
**DE FR GB IT**

(56) Entgegenhaltungen:
**US-A- 4 025 997**

**UND-ODER-NOR + STEUERUNGSTECHNIK, vol. 15, No. 3, 1 March 1985 (München, DE), A. NEIDIG et al : "Leistungshalbleiter-Module in neuer Technologie", pages 32-33.**

(73) Patentinhaber: **DODUCO GMBH + Co Dr. Eugen Dürrwächter**
**Im Altgefäll 12**
**D-75181 Pforzheim(DE)**

(72) Erfinder: **MARTIN, Wolfram**
**Amselweg 11**
**D-7534 Birkenfeld(DE)**
Erfinder: **WAIBEL, Brigitte**
**Nägelishaldenstr. 8**
**D-7530 Pforzheim(DE)**

(74) Vertreter: **Twelmeier, Ulrich, Dipl.Phys. et al**
**Patentanwälte Dr. Rudolf Bauer**
**Dipl.-Ing.Helmut Hubbuch, Dipl.Phys. Ulrich Twelmeier**
**Westliche Karl-Friedrich-Strasse 29-31**
**D-75172 Pforzheim (DE)**

## Beschreibung

Die Erfindung geht aus von einem flachen Körper mit den im Oberbegriff des Anspruchs 1 angegebenen Merkmalen. Solche flachen Körper, welche z.B. aus einer dünnen Aluminiumoxidplatte bestehen, die beidseitig mit je einer Metallplatte bedeckt ist, sind als Wärmesenken für elektronische Leistungsbauelemente, z.B. in Zündvorrichtungen für Ottomotoren in Automobilen, bekannt. Dort müssen diese Körper eine hohe Temperaturwechselbeständigkeit aufweisen. Die Temperaturwechselbeständigkeit ist bei den bisher bekannten Körpern unzureichend, weil die Wärmeausdehnungskoeffizienten der Keramikplatte einerseits und der Metallplatten andererseits sich stark unterscheiden, so dass bei Temperaturwechseln in dem Körper entsprechend stark wechselnde Zug- und Druckspannungen parallel zur Oberfläche entstehen, die zu einem Bruch in der Keramikplatte parallel zur Oberfläche (Muschelbruch) führen können. Mangelnde Temperaturwechselbeständigkeit ist insbesondere dann gegeben, wenn die Metallplatten ohne eine Zwischenschicht mit der Keramikplatte verbunden sind (Direct Bonding-Verfahren). Eine Zwischenschicht aus einer Lotlegierung, die gute Duktilität aufweist, kann die auftretenden Wärmespannungen teilweise ausgleichen.

Der Erfindung liegt die Aufgabe zugrunde, flache Körper der eingangs genannten Art mit verbesserter Temperaturwechselbeständigkeit verfügbar zu machen.

Diese Aufgabe wird gelöst durch flache Körper mit den im Anspruch 1 angegebenen Merkmalen. Vorteilhafte Weiterbildungen der Erfindung sind Gegenstand der Unteransprüche.

Es hat sich gezeigt, dass ein beidseitig von Metallplatten bedecktes Substrat eine beträchtlich erhöhte Temperaturwechselbeständigkeit hat, wenn die Metallplatten Randstreifen mit verminderter Dicke haben. Zur Ausbildung dieser Randstreifen können die Metallplatten abgeschrägt sein, wobei eine Abschrägung unter einem Winkel von ungefähr 20° zur Oberfläche der Keramikplatte besonders geeignet ist. Vorzugsweise setzt man jedoch Metallplatten ein, deren Dicke am Rand stufenweise vermindert ist, wobei es zur Erzielung einer wesentlichen Erhöhung der Temperaturwechselbeständigkeit schon ausreicht, die Randstreifen nur einfach abgestuft auszubilden; die Temperaturwechselbeständigkeit kann jedoch noch verbessert werden, wenn man die Dicke der Metallplatten zum Rand hin in mehreren Stufen reduziert. Bei einer nur einfachen Abstufung empfiehlt es sich, die Dicke des Randstreifens zu 40 % bis 50 %, am besten vorzugsweise ungefähr zu 45 % der Dicke der Metallplatten zu wählen.

Als Breite der Randstreifen mit verminderter Dicke wählt man zweckmässigerweise das 1- bis 3-fache, am besten das 1,5- bis 2-fache der Dicke der Metallplatten.

Die größte Verbesserung der Temperaturwechselbeständigkeit erreicht man, wenn man die Metallplatten an allen Rändern, also umlaufend mit Randstreifen verminderter Dicke ausbildet. Will man das beispielsweise aus Gründen einer preiswerteren Fertigung jedoch nicht, dann empfiehlt es sich, die Metallplatten stets an einander entgegengesetzt gerichteten Rändern mit Randstreifen verminderter Dicke auszubilden. Fertigungstechnisch besonders günstig ist es, rechteckige Metallplatten einzusetzen, die an zwei parallelen Rändern abgestuft ausgebildet sind; solche Metallplatten kann man fortlaufend aus einem Metallband herstellen, an dessen beiden Längsrändern die dünneren Randstreifen durch Fräsen gebildet werden und welches anschließend in einzelne Metallplatten zerteilt wird.

Zur Erzielung einer hohen Temperaturwechselbeständigkeit empfiehlt es sich ferner, die Metallplatten auf beiden Seiten der Keramikplatte gleich auszubilden und deckungsgleich anzuordnen, damit die Keramikplatte bei Temperaturwechseln nicht zusätzlich auf Biegung beansprucht wird.

Die Erfindung erlaubt es insbesondere, hochtemperaturwechselbeständige Körper herzustellen, die aus einer dünnen Keramikplatte bestehen, die mit Metallplatten aus einem besonders gut wärmeleitfähigen Metall, insbesondere aus Kupfer, direkt verbunden sind. Der Nachteil, den bekannte im Direct-Bonding-Verfahren beschichtete Körper gegenüber gelöteten Körpern hinsichtlich der Temperaturwechselbeständigkeit haben, wird bei der erfindungsgemäßen Ausbildung der Körper mehr als ausgeglichen und damit der Anwendungsbereich des Direct-Bonding-Verfahrens als Fügeverfahren erweitert. Die Erfindung ist aber natürlich auch anwendbar auf solche sandwichartig zusammengefügte Körper, die auf andere Weise als im Direct-Bonding-Verfahren, insbesondere durch Löten zusammengefügt worden sind. Als Werkstoff für die Keramikplatten wird man zweckmässigerweise Aluminiumoxid wählen, es ist aber auch möglich, andere keramische Werkstoffe, insbesondere Aluminiumnitrid und Berylliumoxid zu verwenden.

In der bevorzugten Verwendung der Körper als Wärmesenke für elektronische Leistungsbauelemente wählt man für die Keramikplatten ebenso wie für die Metallplatten am besten Dicken zwischen 0,5 mm und 1 mm.

Zur weiteren Erläuterung der Erfindung ist eine Zeichnung beigefügt, die in

Figur 1      einen flachen Körper gemäß dem Stand der Technik in der Draufsicht, in

Figur 2      denselben Körper in einer Seitenansicht, in

Figur 3    einen erfindungsgemäßen Körper mit abgeschrägten Metallplatten in der Draufsicht, in
Figur 4    den Körper aus Fig. 3 in einer Seitenansicht, in
Figur 5    einen erfindungsgemäßen Körper mit abgestuften Rändern in der Draufsicht, und in
Figur 6    den Körper aus Fig. 5 in einer Seitenansicht zeigt.

Zur Vereinfachung sind in den unterschiedlichen Figuren einander entsprechende Teile mit übereinstimmenden Bezugszahlen bezeichnet.

In allen drei Beispielen besteht der Körper aus einer dünnen, rechteckigen Keramikplatte 1, auf deren Oberseite eine Metallplatte 2 und auf deren Unterseite eine mit der Metallplatte 2 übereinstimmende Metallplatte 3 direkt verbunden ist. Die Metallplatten 2, 3 sind ebenfalls rechteckig ausgebildet, etwas kleiner als die Keramikplatte 1 und mittig auf der Keramikplatte 1 angeordnet, so dass zwischen den Metallplatten 2 und 3 ein Randstreifen 4 der Keramikplatte übersteht. Die Dicke der Metallplatten 2 und 3 liegt in derselben Größenordnung wie die Dicke der Keramikplatte 1.

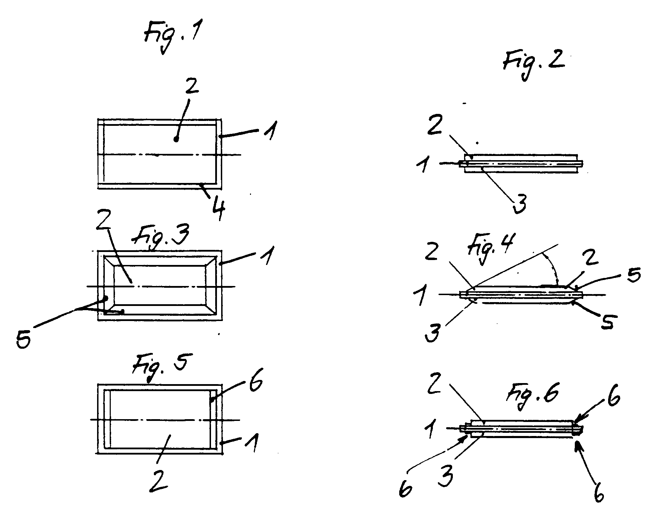

Bei dem dem Stand der Technik angehörenden Körper in den Figuren 1 und 2 sind die Metallplatten 2 und 3 flache Quader, wohingegen bei den in den Figuren 3 bis 6 dargestellten beiden Ausführungsbeispielen die Metallplatten Randstreifen 5 bzw. 6 mit verminderter Dicke haben. Bei dem in den Figuren 3 und 4 dargestellten Ausführungsbeispiel ist der Randstreifen 5 durch Schrägflächen begrenzt und an allen vier Rändern der Metallplatten 2 und 3 ausgebildet. Bei dem in den Figuren 5 und 6 dargestellten Ausführungsbeispiel ist an den beiden Schmalseiten der Metallplatten 2 und 3, zwischen denen die größten Wärmespannungen auftreten, zur Bildung des dünneren Randstreifens 6 jeweils eine Stufe ausgebildet, deren Dicke weniger als die Hälfte der Dicke der Metallplatten beträgt.

Zur Beleuchtung des technischen Fortschrittes sind nachstehend die Ergebnisse von Vergleichsversuchen angegeben, die mit Körpern durchgeführt wurden, weil sie in den Abbildungen 1 bis 6 dargestellt sind.

In allen Fällen wurden Aluminiumoxidkeramikplatten mit den Maßen

| Länge | 23,2 mm |
|-------|---------|
| Breite | 13,2 mm |
| Dicke | 0,635 mm |

verwendet, die mit Kupferplatten mit den Maßen

| Länge | 21,0 mm |
|-------|---------|
| Breite | 11,0 mm |
| Dicke | 0,65 mm |

im Direct-Bonding-Verfahren beschichtet waren.

Im Ausführungsbeispiel gemäß den Figuren 3 und 4 waren die Randstreifen 5 unter einem Winkel von 20° zur Oberfläche der Keramikplatte 1 abgeschrägt, im Ausführungsbeispiel gemäß den Figuren 5 und 6 waren Randstreifen 6 mit einer Breite von 1,0 mm und einer Dicke von 0,3 mm gebildet. Eine größere Anzahl von Prüflingen wurde einer Temperaturwechselbeanspruchung zwischen -40°C und +110°C unterworfen, wobei die Prüflinge jeweils 40 Minuten lang bei der unteren und bei der oberen Temperatur gehalten wurden und binnen einer Umlagerzeit von höchstens 10 s zwischen der unteren und der oberen Temperatur umgelagert wurden.

Die nachstehende Tabelle gibt die Ausfälle in % von Prüflingen an, die nach thermischen Lastwechseln beobachtet wurden.

| Prüflinge gemäß Figuren | Anzahl thermischer Lastwechsel | | | | | | | | | | | | |
|---|---|---|---|---|---|---|---|---|---|---|---|---|---|
| | 20 | 30 | 45 | 60 | 75 | 99 | 140 | 184 | 225 | 266 | 307 | 348 | 389 |
| 1 und 2 | 0 | 0 | 10 | 20 | 30 | 30 | 100% | | | | | | |
| 3 und 4 | 0 | 0 | 0 | 0 | 0 | 0 | 0 | 0 | 10 | 30 | 40 | 70 | 100% |
| 5 und 6 | 0 | 0 | 0 | 0 | 0 | 0 | 0 | 0 | 10 | 10 | 30 | 50 | 60% |

**Patentansprüche**

1. Als flacher Körper ausgebildetes Substrat
   für elektronische Leistungsbauelemente, bestehend aus einer Keramikplatte, welche beidseitig von Metallplatten bedeckt ist, die auf ihrer gesamten Auflagefläche fest mit der Keramikplatte verbunden sind,
   dadurch gekennzeichnet, daß die Metallplatten (2, 3) zur Erhöhung der Temperaturwechselbeständigkeit Randstreifen (5, 6) mit verminderter Dicke haben.

EP 0 322 434 B1

**2.** Substrat nach Anspruch 1, dadurch gekennzeichnet, daß
die beiden Metallplatten (2, 3) ohne eine Zwischenschicht mit der Keramikplatte (1) verbunden sind.

**3.** Substrat nach Anspruch 1 oder 2, dadurch gekennzeichnet,
daß die auf beiden Seiten der Keramikplatte angebrachten Metallplatten (2, 3) deckungsgleich angeordnet sind.

**4.** Substrat nach Anspruch 1, 2 oder 3, dadurch gekennzeichnet,
daß die auf beiden Seiten der Keramikplatte angebrachten Metallplatten (2, 3) gleich ausgebildet sind.

**5.** Substrat nach einem der vorhergehenden Ansprüche,
dadurch gekennzeichnet, daß die Metallplatten (2, 3) aus Kupfer bestehen.

**6.** Substrat nach einem der vorhergehenden Ansprüche,
dadurch gekennzeichnet, daß die Randstreifen (5) der Metallplatten (2, 3) abgeschrägt sind.

**7.** Substrat nach Anspruch 6, dadurch gekennzeichnet,
daß die Randstreifen (5) unter einem Winkel von ungefähr 20° zur Oberfläche der Keramikplatte (1) abgeschrägt sind.

**8.** Substrat nach einem der Ansprüche 1 bis 5, dadurch
gekennzeichnet, daß die Randstreifen (6) der Metallplatten (2, 3) abgestuft sind.

**9.** Substrat nach Anspruch 8, dadurch gekennzeichnet,
daß die Randstreifen (6) einfach abgestuft sind und ihre Dicke 40 % bis 50 %, vorzugsweise ungefähr 45 % der Dicke der Metallplatten (2, 3) beträgt.

**10.** Substrat nach einem der vorhergehenden Ansprüche, dadurch
gekennzeichnet, daß die Breite der Randstreifen (5, 6) mit verminderter Dicke das 1- bis 3-fache, vorzugsweise das 1,5- bis 2-fache der Dicke der Metallplatten (2, 3) beträgt.

**11.** Substrat nach einem der vorhergehenden Ansprüche,
dadurch gekennzeichnet, daß die Dicke der Metallplatten (2, 3) sowie der Keramikplatte (1) 0,5 mm bis 1 mm beträgt.

**Claims**

**1.** A substrate in the shape of a flat body for electronic
power components, consisting of a ceramic slab, which is covered on both sides by metal plates which are firmly joined to the ceramic slab throughout their total contact surface,
characterized in that to improve the resistance against temperature cycles the metal plates (2, 3) have marginal strips (5, 6) which are reduced in thickness.

**2.** A substrate according to claim 1, characterized in that
the two metal plates (2, 3) are joined to the ceramic slab (1) without an interlayer.

**3.** A substrate according to claim 1 or 2, characterized
in that the metal plates (2, 3) attached to both sides of the ceramic slab are arranged to be coextensive.

**4.** A substrate according to claim 1, 2 or 3, characterized
in that the metal plates (2, 3) attached to both sides of the ceramic slab are identical.

**5.** A substrate according to any of the preceding claims,
characterized in that the metal plates (2, 3) are made of copper.

5

**6.** A substrate according to any of the preceding claims,
characterized in that the marginal strips (5) of the metal plates (2, 3) are beveled.

**7.** A substrate according to claim 6, characterized in that
the marginal strips (5) are beveled at an angle of about 20° to the surface of the ceramic slab (1).

**8.** A substrate according to any of claims 1 to 5, characterized
in that the marginal strips (6) of the metal plates (2, 3) are stepped.

**9.** A substrate according to claim 8, characterized in that
the marginal strips (6) are stepped once and have a thickness of 40 % to 50 %, preferably about 40 %, of the thickness of the metal plates (2, 3).

**10.** A substrate according to any of the preceding claims,
characterized in that the marginal strips (5, 6) reduced in thickness have a width which is 1 to 3 times, preferably 1.5 to 2 times, the thickness of the metal plates (2, 3).

**11.** A substrate according to any of the preceding claims,
characterized in that the metal plates (2, 3) and the ceramic plates (1) have a thickness of 0.5 mm to 1 mm.

**Revendications**

**1.** Substrat en forme de corps plat pour composants électroniques de puissance, constitué d'une plaque céramique qui est recouverte des deux côtés de plaques métalliques, lesquelles sont solidement reliées, sur l'ensemble de leur face d'application, à la plaque céramique, caractérisé en ce que les plaques métalliques (2, 3), afin d'augmenter leur résistance aux températures alternées, présentent des bandes de bord (5, 6) d'épaisseur réduite.

**2.** Susbtrat selon la revendication 1, caractérisé en ce que les deux plaques métalliques (2, 3) sont assemblées à la plaque céramique (1) sans une couche intermédiaire.

**3.** Substrat selon la revendication 1 ou 2, caractérisé en ce que les plaques métalliques (2, 3) fixées sur les deux faces de la plaque céramique sont disposées de manière à se recouvrir de manière identique.

**4.** Substrat selon la revendication 1, 2 ou 3, caractérisé en ce que les plaques métalliques (2, 3) fixées sur les deux faces de la plaque céramique sont de configuration identique.

**5.** Substrat selon l'une des revendications précédentes, caractérisé en ce que les plaques métalliques (2, 3) sont en cuivre.

**6.** Substrat selon l'une des revendications précédentes, caractérisé en ce que les bandes de bord (5) des plaques métalliques (2, 3) sont biseautées.

**7.** Substrat selon la revendication 6, caractérisé par le fait que les bandes de bord (5) sont biseautées en formant un angle d'environ 20° par rapport à la surface de la plaque céramique (1).

**8.** Substrat selon l'une des revendications 1 à 5, caractérisé en ce que les bandes de bord (6) des plaques métalliques (2, 3) sont en forme de gradins.

**9.** Substrat selon la revendication 8, caractérisé en ce que les bandes de bord (6) sont à simples gradins et que leur épaisseur est égale à 40 à 50 % de celle des plaques métalliques (2, 3).

**10.** Substrat selon l'une des revendications précédentes, caractérisé en ce que la largeur des bandes de bord (5, 6) à épaisseur réduite est égale à 1 à 3 fois, de préférence de 1,5 à 2 fois, l'épaisseur des plaques métalliques (2, 3).

**EP 0 322 434 B1**

**11.** Substrat selon l'une des revendications précédentes, caractérisé en ce que l'épaisseur des plaques métalliques (2, 3) ainsi que celle de la plaque céramique (1), est de 0,5 à 1 mm.

7

Fig.1

Fig.2

Fig.3

Fig.4

Fig.5

Fig.6